(19) Europäisches Patentamt
European Patent Office
Office européen des brevets

(11) **EP 3 465 846 B1**

(12) **FASCICULE DE BREVET EUROPEEN**

(45) Date de publication et mention
de la délivrance du brevet:
**02.12.2020 Bulletin 2020/49**

(21) Numéro de dépôt: **17726595.6**

(22) Date de dépôt: **23.05.2017**

(51) Int Cl.:
*H01S 5/22* *(2006.01)*    *H01S 5/34* *(2006.01)*
*H01S 5/40* *(2006.01)*

(86) Numéro de dépôt international:
**PCT/EP2017/062352**

(87) Numéro de publication internationale:
**WO 2017/202815 (30.11.2017 Gazette 2017/48)**

(54) **RESEAU DE LASERS A CASCADE QUANTIQUE A ANTIGUIDAGE ENTERRE DANS UN MATERIAU DE TYPE IV ET A EMISSION MONOLOBE**

ANORDNUNG VON QUANTENKASKADEN, ANTIWELLENGELEITETEN LASERS, EINGEBETTET IN EINEM IV-ARTIGEN MATERIAL UND MIT EINER EINZELNEN STRAHLENKEULE

ARRAY OF ANTIGUIDING QUANTUM CASCADE LASERS BURIED IN A IV-TYPE MATERIAL AND HAVING MONOLOBE EMISSION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **24.05.2016 FR 1600831**

(43) Date de publication de la demande:
**10.04.2019 Bulletin 2019/15**

(73) Titulaire: **Thales**
**92400 Courbevoie (FR)**

(72) Inventeurs:
• **FERRE, Simon**
**76130 Mont-Saint-Aignan (FR)**
• **CARRAS, Mathieu**
**91440 Bures-sur-Yvette (FR)**

(74) Mandataire: **Marks & Clerk France**
**Immeuble "Visium"**
**22, avenue Aristide Briand**
**94117 Arcueil Cedex (FR)**

(56) Documents cités:
WO-A2-2013/174945    US-A1- 2002 101 895
US-A1- 2005 036 530    US-A1- 2015 249 320

EP 3 465 846 B1

**Description**

Le domaine de l'invention est celui des lasers à cascade quantique (ou « QCL » acronyme de l'expression anglo-saxonne Quantum Cascade Laser) de puissance émettant dans le moyen infrarouge. Les lasers de puissance dans le moyen infrarouge (MIR) sont typiquement utilisés en contre-mesure optique et en spectroscopie.

Parmi les lasers de puissance on peut aussi citer les sources à conversion de fréquences (OPO) et les lasers à gaz (CO2). Mais contrairement à ces sources, les QCLs sont une solution compacte, monolithique, robuste, avec un haut rendement énergétique.

On souhaite pouvoir utiliser une source de puissance MIR fonctionnant aussi bien en régime impulsionnel (à forte puissance pic), qu'en régime continu et quasi-continu.

Une solution connue pour augmenter la puissance consiste à utiliser un QCL mono ruban et à augmenter la largeur du ruban. Cependant à partir d'une certaine largeur, la charge thermique devient trop importante pour être efficacement évacuée ce qui conduit à une chute des performances voire à une destruction du laser. Des problèmes optiques apparaissent également avec un fonctionnement multimode qui conduit à un champ lointain très dégradé. Le record de puissance obtenue en régime continu à température ambiante est de 5.1W pour une longueur d'onde de 4.6$\mu$m avec une largeur de ruban de 8 $\mu$m. En régime impulsionnel, le record est de 120W en puissance pic pour une largeur de ruban de 400$\mu$m à 4.45$\mu$m de longueur d'onde. Pour ces structures, le champ lointain n'est pas monolobe (un seul pic en champ lointain) ni monomode et il se dégrade fortement lorsqu'on augmente le courant traversant le laser.

Une solution pour dissiper efficacement la charge thermique et être monomode, est de séparer un large ruban en plusieurs micro-rubans couplés optiquement. Cela permet d'augmenter la dissipation latérale et de maîtriser le mode latéral.

Il existe des lasers QCL à réseaux de micro-rubans couplés, émettant autour de 4.6$\mu$m et 8.2$\mu$m, dont les micro-rubans sont enterrés dans de l'InP:Fe d'indice de réfraction $n_e$ inférieur à celui des zones actives formées par les micro-rubans ($n_{za}$) ; un micro-ruban seul, lorsque $n_e < n_{za}$ supporte des modes guidés. Lorsque l'on rapproche ces rubans, comme dans la configuration citée ci-dessus, les modes de chaque micro-ruban se couplent de façon évanescente, ce qui nécessite un espacement entre rubans le plus faible possible pour garantir un couplage élevé. Les lasers obtenus dans cette configuration à modes guidés présentent tous un champ lointain bilobe typique d'un couplage évanescent. En outre leur fabrication nécessite une technique d'épitaxie difficile à mettre en œuvre, peu répandue et coûteuse afin de remplir l'espace entre les rubans avec le matériau d'indice $n_e$ qui est habituellement de l'InP :Fe. A 8.2$\mu$m, une puissance pic de 250mW pic a été obtenue en régime impulsionnel avec des largeurs effectives des rubans de 8$\mu$m. On rappelle que la largeur effective d'un réseau de micro-rubans est la somme des largeurs de ses micro-rubans. A 4.6$\mu$m, des puissances pics de 400mW ont été atteintes pour des largeurs effectives de 16$\mu$m. Un fonctionnement en continu ou quasi-continu n'est pas recommandé en raison de la charge thermique.

Une autre approche consiste à utiliser un matériau à indice plus fort, tel que $n_e > n_{za}$ ; on parle alors de structure antiguidée, les rubans ne supportant pas de mode confiné contrairement au mode guidé vu précédement.

De telles structures ont été fabriquées en remplaçant l'InP:Fe par un bicouche InP:Fe/InGaAs dont l'indice optique est plus élevé que celui des micro-rubans formant les zones actives. Cela ne suffit pas pour obtenir des lasers monolobes. Il faut ajouter un mécanisme introduisant des pertes sur les modes non désirés, ce qui a été fait en introduisant une métallisation particulière sur le dispositif. Mais cette métallisation est une source de dégradation des performances du laser du point de vue de la puissance.

En ajustant l'espacement entre les rubans, on peut obtenir un champ lointain monolobe avec une puissance pic de 5.5W (4.5W dans le lobe principal) à 8.36$\mu$m avec un rapport cyclique de 0.05 % et une largeur de ruban effective de 105$\mu$m, soit une puissance moyenne de seulement 2.75mW. Le problème de ces structures est que la faible conductivité thermique résultante du bicouche ainsi que la largeur importante des rubans lasers entrainent une mauvaise dissipation thermique, empêchant un fonctionnement en régime continu ou quasi-continu. De plus, le filtrage par les pertes dans le métal réduit le gain de la structure et donc la puissance de sortie. Ces composants à antiguidage dans le bicouche InP:Fe/InGaAs demandent plusieurs étapes de recroissance de matériau cristallin, ce qui est coûteux et augmente grandement la complexité de fabrication, et diminue les tolérances aux défauts de fabrication.

WO2103174945 décrit un laser comportant un réseau de micro rubans de lasers à cascade quantiques qui ont de largeurs prédéterminées forment des zones actives avec un indice de réfraction $n_{za}$ et espacées entre elles par un matériau inter rubans d'indice de réfraction $n_e$ supérieur à $n_{za}$. Les zone actives sont des hétérostructure de matériaux III-V, les espacements entre zones actives est déterminé pour obtenir un super mode d'émission antiguidé symétrique.

En conséquence, il demeure à ce jour un besoin pour un laser de puissance IR donnant simultanément satisfaction à l'ensemble des exigences précitées, en termes de puissance optique moyenne et de rendement à la prise (permis par une bonne dissipation thermique), d'émission monolobe et de coût et de facilité de fabrication.

Plus précisément l'invention a pour objet un laser comportant un réseau de micro rubans de lasers à cascade quantique de longueur d'onde d'émission prédéterminée, les micro rubans de largeurs prédéterminées formant des zones actives d'indice de réfraction $n_{za}$ et espacées entre elles par un matériau inter rubans d'indice de réfraction $n_e$,

avec $n_{za} < n_e$. Il est principalement caractérisé en ce que le matériau inter rubans est de type IV et chaque espacement entre zones actives est déterminé à partir de la longueur d'onde, de la largeur de tous les micro rubans et des indices de réfraction $n_{za}$ et $n_e$, pour obtenir un super mode d'émission antiguidé symétrique lesdites zones actives étant des hétérostructures de matériaux III-IV.

Selon une caractéristique de l'invention, le matériau de type IV est typiquement du Silicium ou du Germanium.

L'utilisation d'un matériau de type IV tel que du Silicium ou du Germanium et de zones actives à matériaux III-V, permet d'avoir une différence d'indice positive ($n_e$-$n_{za}$>0) éventuellement très importante ($n_e$-$n_{za}$>0.1), ce qui permet ainsi au laser d'émettre sur des super modes antiguidés concentrant la puissance en champ lointain dans un lobe centré. De manière pratique, on pourra utiliser un matériau amorphe qui est plus aisé à synthétiser en particulier sur un substrat de type III-V. Le Silicium ou le Germanium amorphe sont également des matériaux avec de faibles pertes dans le moyen infrarouge, et ils assurent un drain thermique suffisant pour permettre un fonctionnement en continu ou quasi-continu. Enfin, le Silicium ou le Germanium sont des isolants électriques, ce qui est nécessaire pour ne pas court-circuiter la zone active.

Par rapport à un couplage évanescent où l'espacement entre les rubans doit être le plus faible possible pour garantir un couplage élevé, le couplage par antiguidage permet d'avoir des espacements plus importants entre les rubans et ainsi relâche les contraintes technologiques. En outre, l'espacement entre les modes permet de choisir le mode antiguidé que l'on veut voir laser.

De plus, le Silicium ou le Germanium amorphe est un matériau beaucoup moins contraignant que l'InP:Fe ou le InGaAs en terme de dépôt, ce qui réduit la complexité et le coût de production.

Les espacements peuvent être identiques ; de même les largeurs des micro rubans peuvent être identiques.

Les zones actives formant une zone active effective, et le réseau de micro rubans comportant deux rubans périphériques, ledit matériau est avantageusement aussi disposé sur les flancs externes des rubans périphériques sur une largeur S ≥0 déterminée en fonction de l'espacement D entre zones actives et d'un recouvrement du super mode avec la zone active effective.

Le laser a par exemple une longueur d'onde d'émission comprise entre 3,5 $\mu$m et 10 $\mu$m.

Le réseau comporte par exemple de 4 à 20 micro rubans.

L'invention a aussi pour objet un procédé de fabrication d'un laser tel que décrit, à partir d'un empilement sur un substrat d'indice de réfraction $n_s$, d'une couche d'un matériau de zone active d'indice de réfraction $n_{za}$, avec $n_s < n_{za}$, et d'une couche de confinement supérieur d'indice de réfraction $n_{cs}$, avec $n_{cs} < n_{za}$, qui comporte une étape de gravure desdites couches jusqu'au substrat pour former les micro rubans sur le substrat, caractérisé en ce qu'il comporte en outre les étapes suivantes :

a) dépôt en une seule couche du matériau de type IV sur les micro rubans et le substrat,
a) retrait du matériau de type IV déposé sur les micro rubans et sur le substrat tout en laissant ledit matériau sur les flancs externes des micro rubans périphériques sur une largeur prédéterminée S,
b) dépôt d'une couche diélectrique de passivation sur les bords du matériau et sur le substrat, ainsi que sur d'autres parties du composant si nécessaire,
c) dépôt d'une couche métallique de contact.

D'autres caractéristiques et avantages de l'invention apparaîtront à la lecture de la description détaillée qui suit, faite à titre d'exemple non limitatif et en référence aux dessins annexés dans lesquels :

les figures 1 représentent schématiquement des exemples de laser à super mode antiguidé symétrique selon l'invention (fig 1a et 1c) et des exemples de laser à super mode antiguidé antisymétrique (fig 1b et 1d),
les figures 2 illustrent schématiquement pour un seul ruban, un mode guidé (fig 2a) et un mode antiguidé (fig 2b), avec les indices de réfraction (en haut des figures), et l'amplitude du champ électrique correspondant (en bas des figures),
la figure 3 représente schématiquement un exemple de laser selon l'invention avec du matériau de type IV sur les flancs externes des rubans périphériques,
la figure 4 illustre la relation entre la distance D entre rubans, l'épaisseur S du matériau sur les flancs externes et le recouvrement du supermode avec les zones actives.

D'une figure à l'autre, les mêmes éléments sont repérés par les mêmes références.

Dans la mesure où le dispositif peut être positionné selon d'autres orientations, la terminologie directionnelle est indiquée à titre d'illustration et n'est pas limitative.

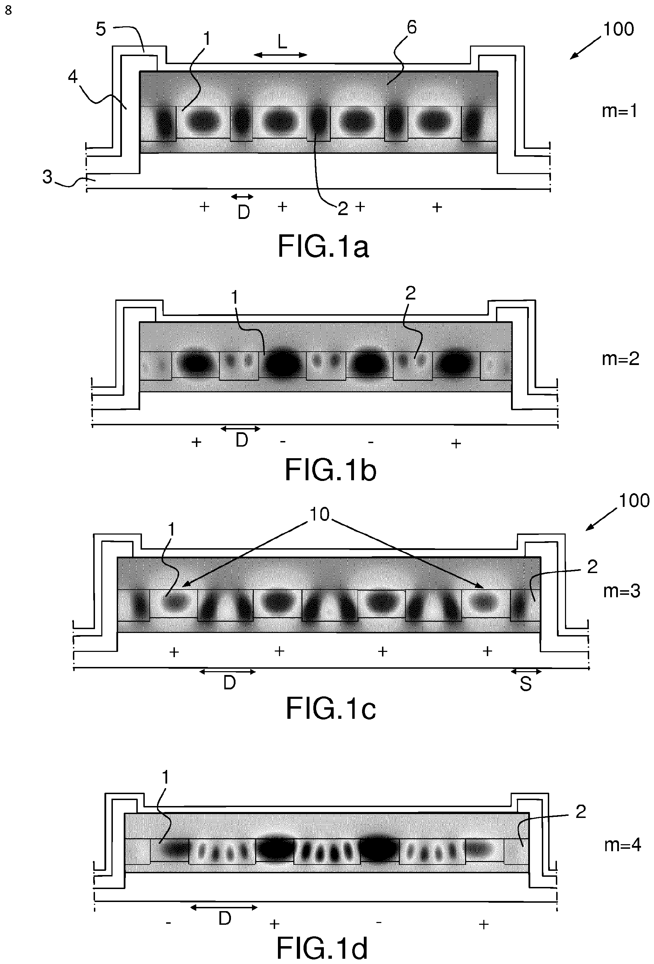

On décrit en relation avec les figures 1a et 1c un exemple de laser 100 selon l'invention. Il comporte un réseau de micro rubans de lasers à cascade quantiques de longueur d'onde d'émission $\lambda$ prédéterminée. Les micro rubans de largeurs $L_1$, ..., $L_K$, prédéterminées (K étant le nombre de micro rubans) qui peuvent être identiques pour tous les micro

rubans ($L_1 = L_K = L$) mais pas nécessairement, forment des zones actives 1 d'indice de réfraction $n_{za}$ qui sont espacées entre elles d'une largeur (ou espacement) D par un matériau inter-ruban 2 d'indice de réfraction $n_e$. Ces espacements peuvent être identiques mais pas nécessairement. On a $n_{za} < n_e$ de manière à obtenir un réseau à super mode antiguidé. Le matériau inter-ruban est un matériau de type IV tel que du Silicium ou du Germanium et chaque espacement D entre deux micro rubans adjacents (ou deux zones actives adjacentes) est déterminé à partir de la longueur d'onde $\lambda$, de toutes les largeurs $L_1$, ..., $L_K$, des micro rubans et des indices de réfraction $n_{za}$ et $n_e$ pour obtenir un super mode antiguidé symétrique. On désigne par super mode le mode résultant de l'ensemble du laser 100. Les super modes permis sont au premier ordre des combinaisons linéaires des modes des seules zones actives 1. Le super mode favorisé est celui qui a un gain modal (et donc un recouvrement) le plus grand avec celui de la zone active.

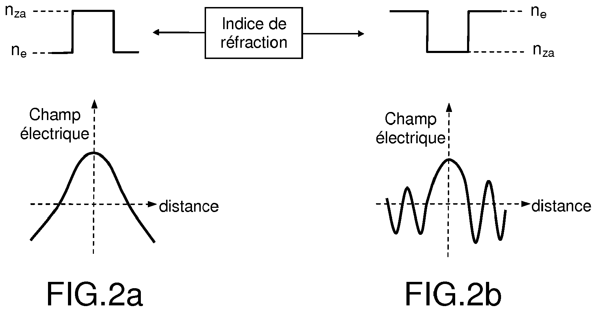

On rappelle que lorsque $n_{za} > n_e$, on a pour chaque zone active 1 un mode guidé et le champ électrique décroît exponentiellement en fonction de la distance mesurée à partir du cœur de la zone active comme illustré figure 2a pour un seul ruban. C'est le cas avec un couplage évanescent entre des rubans étroits séparés entre eux par de l'InP:Fe : on choisit des largeurs $L_1$, ..., $L_K$, des rubans suffisamment étroites pour que pris séparément, chacun des rubans ne permette que le mode fondamental. Il est sinusoïdal dans la zone active et exponentiel décroissant dans l'InP:Fe. Avec plusieurs rubans, les super modes sont en première approximation des combinaisons linéaires des modes des rubans pris séparément. Le supermode antisymétrique est favorisé (le champ dans les zones actives change de signe entre plus proches voisins : + - + - + -, ...), ce qui donne un champ lointain bilobe. L'espacement entre les micro-rubans n'influe alors que sur la force du couplage entre eux.

En remplissant l'espace entre les micro-rubans par un matériau de type IV tel que du silicium, on rend possible l'existence de super modes antiguidés, l'indice optique du silicium étant plus élevé que celui de la zone active ($n_{za} < n_e$). Dans ce cas, le mode des rubans individuels est sinusoïdal dans la zone active mais également en dehors, dans le silicium, avec une amplitude plus faible comme on le voit dans la figure 2b pour un seul ruban ; on parle de modes de fuites (« leaky modes » ou « leaky waves » en anglais). Dans ce cas, l'espacement entre les micro-rubans a un impact différent de celui joué dans la configuration de micro-rubans à modes guidés. En effet, la résonance des super modes antiguidés symétriques (le champ dans les zones actives est de signe invariant) et antisymétriques (le champ dans les zones actives change de signe entre plus proches voisins) est obtenue théoriquement pour un espace inter-ruban D donné par :

$$D = \frac{m\lambda_{leak}}{2} \qquad\qquad \lambda_{leak} = \frac{\lambda}{\sqrt{(n_{Si}^2 - n_{ZA}^2 + (\frac{\lambda}{2L})^2)}}$$

lorsque les espacements sont identiques et où m est un entier positif qui est défini comme le nombre d'extrema dans l'oscillation entre les micro rubans, $n_{Si}$ (ou $n_e$) et $n_{za}$ sont les indices optiques du matériau de type IV et de la zone active respectivement, $\lambda$ la longueur d'onde d'émission du laser 100, $\lambda_{leak}$ la périodicité spatiale de la partie du super mode oscillant entre deux rubans, et L la largeur des micro-rubans identique pour tous ($L_1 = L_K = L$).

Pour m impair, le super mode symétrique est favorisé comme illustré figures 1a et 1c et pour m pair, le super mode antisymétrique comme illustré figures 1b et 1d.

Lorsque les largeurs des micro rubans varie d'un ruban à l'autre, on détermine chaque espacement D entre deux micro rubans par simulation des modes optiques de sorte que le recouvrement du mode souhaité avec les zones actives adjacentes soit maximal.

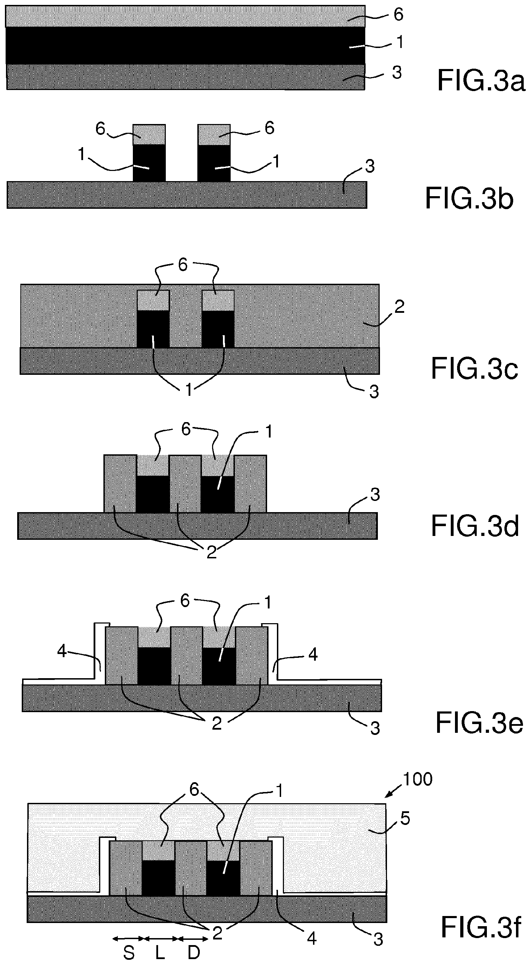

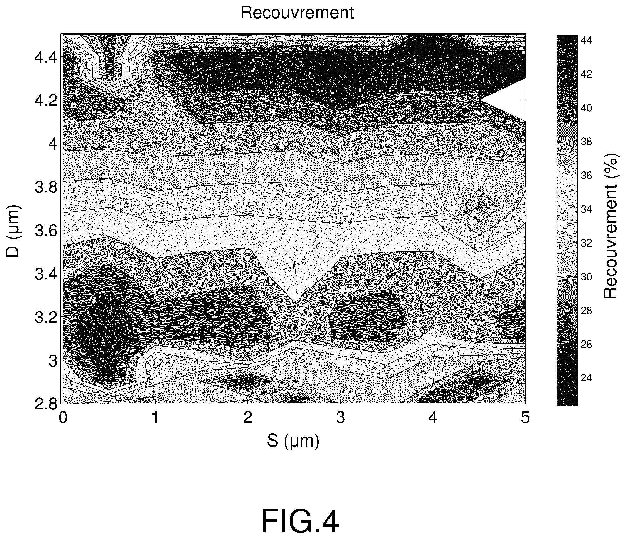

Si on laisse uniquement du matériau de type IV sur les bords des micro-rubans périphériques 10 montrés figures 1, le super mode va aussi osciller dans toute cette région, ce qui réduit le recouvrement avec la zone active et donc le gain modal. Pour éviter cela on grave le matériau de type IV excédentaire pour n'en laisser qu'une zone étroite sur les flancs externes des rubans périphériques, comme montré sur les figures 1 et sur la figure 3. En jouant sur l'épaisseur S de cette zone, on peut changer le recouvrement et la nature du super mode dominant. Sur la figure 4, on montre le recouvrement du super mode ayant le recouvrement maximal en fonction de S (en abscisses) et de la distance D entre les micro-rubans (en ordonnées). Pour cette simulation, L=2 $\mu$m, $\lambda$=4.5 $\mu$m, on a 8 micro-rubans, D varie de 2.8 $\mu$m à 4.5 $\mu$m et S varie de 0 $\mu$m à 5 $\mu$m. On voit que même si la résonance est toujours autour d'une même distance D entre les micro-rubans de 3.1 $\mu$m dans notre simulation, la valeur du recouvrement du super mode dominant peut fortement fluctuer avec S. Il est maximal pour une valeur S non nulle (S= 0.5 dans notre simulation) et a tendance à diminuer globalement lorsque S croît car on laisse le super mode faire plus d'oscillations hors de la zone active. La périodicité des maxima est liée à celle des oscillations du super mode dans cette région. Cela corrobore le fait que le couplage antiguidé est plus sensible aux pertes latérales que le couplage évanescent, le champ étant plus intense en bord de composant, et que ces pertes peuvent être utilisées pour filtrer les supermodes indésirables.

On peut donc choisir D et S par le calcul et la simulation pour obtenir le super mode d'émission souhaité.

Pour fabriquer un laser à super mode antiguidé à émission monolobe, on peut procéder de la manière suivante décrite en relation avec les figures 1b, 1d et 3, à partir d'un substrat 3 d'InP ou d'AsGa d'indice de réfraction $n_s < n_{za}$, tenant lieu de couche de confinement inférieur du mode des zones actives 1. Le substrat a typiquement une épaisseur comprise entre 100 $\mu$m et 1 mm. On dépose sur ce substrat un empilement d'une couche d'un matériau de zone active 1 d'indice de réfraction $n_{za}$, d'épaisseur comprise entre 300 nm et 10 $\mu$m, et d'une couche de confinement supérieur 6 d'épaisseur comprise entre 2 et 10 $\mu$m qui peut être constituée du même matériau que le substrat mais pas nécessairement. L'indice de réfraction $n_{cs}$ de cette couche de confinement supérieur est tel que $n_{cs}<n_{za}$. La couche de matériau des zones actives est une hétérostructure de matériaux III-V à puits quantiques, telle que AlInAs, GaInAs, AlAs, AlGaAs, GaAs.

Ces deux dernières couches sont gravées jusqu'au substrat pour former des micro rubans, chaque micro-ruban étant destiné à former une zone active 1 recouverte d'une couche de confinement supérieur 6.

Un matériau 2 de type IV d'indice de réfraction $n_e$, avec $n_{za}<n_e$, est déposé en une seule couche sur les micro rubans et sur le substrat pour enterrer les micro rubans dans ledit matériau. De manière pratique, on utilise un matériau 2 de type IV amorphe qui est plus aisé à synthétiser en particulier sur un substrat de type III-V. Ce dépôt est avantageusement réalisé par dépôt en phase vapeur pour obtenir un dépôt épais (de l'ordre de 1 à 5 $\mu$m) et conforme, ou par dépôt par couches atomiques.

Le matériau amorphe 2 déposé sur les micro rubans est retiré et celui déposé sur le substrat est également retiré, de préférence en partie retiré de manière à laisser du matériau amorphe sur les flans externes des micro-rubans périphériques sur une largeur S prédéterminée. Ce matériau 2 est donc présent entre les micro rubans et éventuellement sur ces flancs externes. Ce retrait est réalisé par polissage mécano-chimique et/ou par gravure humide ou sèche ; on peut citer comme exemple de gravure sèche, la gravure ionique réactive utilisant un système de torche à plasma (ou RIE-ICP acronyme de l'expression anglo-saxonne Reactive-Ion Etching-Inductively Coupled Plasma). On peut cependant avoir S=0 et dans ce cas, le matériau de type IV amorphe est entièrement retiré du substrat.

Puis une couche diélectrique 4 de passivation d'épaisseur comprise entre 100 nm et 1.5 $\mu$m telle que de la silice ($SiO_2$) ou du nitrure de silicium ($Si_3N_4$) est déposée sur les bords du matériau 2 et sur le substrat 3, avant de déposer un contact métallique 5 tel qu'un alliage à base d'or (Titane/Platine/Or (Ti/Pt/Au) ou Or/Germanium/Nickel/Or (AuGe/Ni/Au) par exemple) d'épaisseur totale comprise entre 100 nm et 600 nm .

Cette couche diélectrique de passivation 4 peut aussi être déposée sur le matériau 2.

Les domaines d'exploitation principaux pour les lasers de puissance dans le moyen infrarouge sont par exemple la contre-mesure optique et la spectroscopie.

**Revendications**

1. Laser (100) comportant un réseau de micro rubans de lasers à cascade quantiques de longueur d'onde ($\lambda$) d'émission prédéterminée, les micro rubans de largeurs ($L1,...L_K$) prédéterminées formant des zones actives (1) d'indice de réfraction $n_{za}$ et espacées entre elles par un matériau (2) inter rubans d'indice de réfraction $n_e$, avec $n_{za}<n_e$, **caractérisé en ce que** le matériau inter rubans est de type IV et chaque espacement entre zones actives est déterminé à partir de la longueur d'onde ($\lambda$), de la largeur de tous les micro rubans et des indices de réfraction $n_{za}$ et $n_e$, pour obtenir un super mode d'émission antiguidé symétrique, lesdites zones actives étant des hétérostructures de matériaux III-IV.

2. Laser (100) selon la revendication précédente, **caractérisé en ce que** les espacements sont identiques et/ou les largeurs des micro rubans sont identiques.

3. Laser (100) selon l'une des revendications précédentes, **caractérisé en ce que** le matériau de type IV (2) est du Silicium ou du Germanium.

4. Laser (100) selon l'une des revendications précédentes, **caractérisé en ce que** le matériau de type IV (2) est amorphe.

5. Laser (100) selon l'une des revendications précédentes, **caractérisé en ce que** les zones actives (1) formant une zone active effective, le réseau de micro rubans comportant deux rubans périphériques (10), ledit matériau de type IV (2) est aussi disposé sur les flancs externes des rubans périphériques sur une largeur S $\geq$0 déterminée en fonction des espacements entre zones actives et d'un recouvrement du super mode avec la zone active effective.

6. Laser (100) selon l'une des revendications précédentes, **caractérisé en ce que** le laser a une longueur d'onde d'émission comprise entre 3,5 $\mu$m et 10 $\mu$m.

**7.** Laser (100) selon l'une des revendications précédentes, **caractérisé en ce que** le réseau comporte de 4 à 20 micro rubans.

**8.** Procédé de fabrication d'un laser (100) selon l'une des revendications précédentes, à partir d'un empilement sur un substrat (3) d'indice de réfraction $n_s$, d'une couche d'un matériau de zone active (1) d'indice de réfraction $n_{za}$, avec $n_s < n_{za}$, et d'une couche de confinement supérieur (6) d'indice de réfraction $n_{cs}$, avec $n_{cs} < n_{za}$, qui comporte une étape de gravure desdites couches jusqu'au substrat pour former les micro rubans sur le substrat, **caractérisé en ce qu'**il comporte en outre les étapes suivantes :

a) dépôt en une seule couche du matériau de type IV (2) d' indice de réfraction ne, avec $n_{za} < n_e$, sur les micro rubans et le substrat,
b) retrait du matériau de type IV déposé sur les micro rubans et sur le substrat tout en laissant ledit matériau entre les micro rubans et sur les flancs externes des micro rubans périphériques (10) sur une largeur prédéterminée (S),
c) dépôt d'une couche diélectrique de passivation (4) sur les bords du matériau et sur le substrat,
d) dépôt d'une couche métallique de contact (5).

**9.** Procédé de fabrication d'un laser selon la revendication précédente, **caractérisé en ce que** S=0.

**10.** Procédé de fabrication d'un laser selon l'une des revendications 8 à 9, **caractérisé en ce que** l'étape a) est réalisée par dépôt en phase vapeur ou par dépôt par couches atomiques.

**11.** Procédé de fabrication d'un laser selon l'une des revendications 8 à 10, **caractérisé en ce que** l'étape b) est réalisée par polissage mécano-chimique et/ou par gravure sèche ou humide.

**12.** Procédé de fabrication d'un laser selon l'une des revendications 8 à 11, **caractérisé en ce que** le substrat et la couche de confinement supérieur sont en InP ou GaAs.

## Patentansprüche

**1.** Laser (100), umfassend ein Netzwerk von Laser-Mikrobändern mit Quantenkaskade, mit einer vorbestimmten Sende-Wellenlänge ($\lambda$), wobei die Mikrobänder mit vorbestimmten Breiten ($L1,...L_K$) aktive Bereiche (1) mit Brechungsindex $n_{za}$ bilden und untereinander durch ein Band-Zwischenmaterial (2) mit Brechungsindex $n_e$ beabstandet sind, wobei $n_{za} < n_e$, **dadurch gekennzeichnet, dass** das Band-Zwischenmaterial ein Typ IV-Material ist und jeder Abstand zwischen aktiven Bereichen anhand der Wellenlänge ($\lambda$), der Breite aller Mikrobänder und der Brechungsindizes $n_{za}$ und $n_e$ bestimmt wird, um einen symmetrischen, antigeleiteten Super-Sendemodus zu erzielen, wobei die aktiven Bereiche Heterostrukturen aus Typ III-IV-Materialien sind.

**2.** Laser (100) nach dem vorhergehenden Anspruch, **dadurch gekennzeichnet, dass** die Abstände identisch und/oder dass die Breiten der Mikrobänder identisch sind.

**3.** Laser (100) nach einem der vorhergehenden Ansprüche, **dadurch gekennzeichnet, dass** das Typ IV-Material (2) Silizium oder Germanium ist.

**4.** Laser (100) nach einem der vorhergehenden Ansprüche, **dadurch gekennzeichnet, dass** das Typ IV-Material (2) amorph ist.

**5.** Laser (100) nach einem der vorhergehenden Ansprüche, **dadurch gekennzeichnet, dass**, da die aktiven Bereiche (1) einen effektiven aktiven Bereich bilden, wobei das Netzwerk aus Mikrobändern zwei umlaufende Bänder (10) umfasst, das Typ IV-Material (2) ebenfalls an den äußeren Flanken der umlaufenden Bänder über eine Breite S $\geq$ 0 angeordnet ist, welche angesichts der Abstände zwischen aktiven Bereichen und einer Überlappung des Super-Modus mit dem effektiven aktiven Bereich bestimmt wird.

**6.** Laser (100) nach einem der vorhergehenden Ansprüche, **dadurch gekennzeichnet, dass** der Laser eine Sendewellenlänge zwischen 3,5 $\mu$m und 10 $\mu$m aufweist.

**7.** Laser (100) nach einem der vorhergehenden Ansprüche, **dadurch gekennzeichnet, dass** das Netzwerk 4 bis 20 Mikrobänder umfasst.

8. Verfahren zur Herstellung eines Lasers (100) nach einem der vorhergehenden Ansprüche, anhand eines Stapels auf einem Substrat (3) mit einem Brechungsindex $n_s$, einer Schicht aus einem Material eines aktiven Bereichs (1) mit Brechungsindex $n_{za}$, wobei $n_s<n_{za}$, und einer oberen Einschließungsschicht (6) mit Brechungsindex $n_{cs}$, wobei $n_{cs}<n_{za}$, umfassend einen Schritt des Gravierens der Schichten bis zum Substrat zum Bilden der Mikrobänder auf dem Substrat, **dadurch gekennzeichnet, dass** es zudem folgende Schritte umfasst:

a) Ablagern einer einzigen Schicht aus Typ IV-Material (2) mit Brechungsindex $n_e$, wobei $n_{ze} < n_e$, auf den Mikrobändern und dem Substrat,
b) Entfernen des auf den Mikrobändern und auf dem Substrat abgelagerten Typ IV-Materials, wobei das Material zwischen den Mikrobändern und an den äußeren Flanken der umlaufenden Mikrobänder (10) über eine vorbestimmte Breite (S) belassen wird,
c) Ablagern einer dielektrischen Passivierungsschicht (4) an den Rändern des Materials und an dem Substrat,
d) Ablagern einer metallischen Kontaktschicht (5).

9. Herstellungsverfahren eines Lasers nach dem vorhergehenden Anspruch **dadurch gekennzeichnet, dass** S=0 ist.

10. Herstellungsverfahren eines Lasers nach einem der Ansprüche 8 bis 9, **dadurch gekennzeichnet, dass** der Schritt a) durch Ablagerung in der Dampfphase oder durch Ablagerung von Atomschichten bewerkstelligt wird.

11. Herstellungsverfahren eines Lasers nach einem der Ansprüche 8 bis 10, **dadurch gekennzeichnet, dass** der Schritt b) durch mechanisch-chemisches Polieren und/oder durch Trocken- oder Nassgravur bewerkstelligt wird.

12. Verfahren zur Herstellung eines Lasers nach einem der Ansprüche 8 bis 11, **dadurch gekennzeichnet, dass** das Substrat und die obere Einschließungsschicht aus InP oder GaAs bestehen.

**Claims**

1. A laser (100) comprising a network of micro-ridges of quantum cascade lasers of preset emission wavelength (λ), the micro-ridges, which are of preset widths ($L_1,...L_K$), forming active zones (1) of refractive index $n_{za}$ that are spaced apart from each other by an inter-ridge material (2) of refractive index $n_e$, with $n_{za}<n_e$, **characterized in that** the inter-ridge material is a group-IV material. and each spacing between active zones is determined on the basis of the wavelength λ, of the width of all micro-ridges and of the refractive indices $n_{za}$ and $n_e$ in order to obtain a symmetric anti-guided super emission mode, said active zones being heterostructures of III-IV materials.

2. The laser (100) according to the preceding claim, **characterized in that** the spacings are identical and/or the widths of the micro-ridges are identical.

3. The laser (100) according to one of the preceding claims, **characterized in that** the group-IV material (2) is silicon or germanium.

4. The laser (100) according to one of the preceding claims, **characterized in that** the group-IV material (2) is amorphous.

5. The laser (100) according to one of the preceding claims, **characterized in that** with the active zones (1) forming an effective active zone and the network of micro-ridges including two peripheral ridges (10), said group-IV material (2) is also placed on the external flanks of the peripheral ridges over a width S ≥ 0 determined depending on the spacings between active zones and on an overlap of the super mode with the effective active zone.

6. The laser (100) according to one of the preceding claims, **characterized in that** the laser has an emission wavelength comprised between 3.5 μm and 10 μm.

7. The laser (100) according to one of the preceding claims, **characterized in that** the network comprises from 4 to 20 micro-ridges.

8. A process for fabricating a laser (100) according to one of the preceding claims, from a stack, on a substrate (3) of

refractive index $n_s$, of a layer of an active-zone material (1) of refractive index $n_{za}$, with $n_s < n_{za}$, and of a top confinement layer (6) of refractive index $n_{cs}$, with $n_{cs} < n_{za}$, which comprises a step of etching said layers to the substrate in order to form the micro-ridges on the substrate, **characterized in that** it furthermore includes the following steps:

a) depositing, in a single layer, the group-IV material (2) of refractive index $n_e$, with $n_{za} < n_e$ on the micro-ridges and the substrate,
b) removing the group-IV material deposited on the micro-ridges and on the substrate while leaving said material between the micro-ridges and on the external flanks of the peripheral micro-ridges (10) over a preset width (S),
c) depositing a dielectric passivating layer (4) on the edges of the material and on the substrate,
d) depositing a metal contact layer (5).

9. The process for fabricating a laser according to the preceding claim, **characterized in that** S=0.

10. The process for fabricating a laser according to one of claims 8 to 9, **characterized in that** step a) is carried out by vapor deposition or by atomic layer deposition.

11. The process for fabricating a laser according to one of claims 8 to 10, **characterized in that** step b) is carried out by chemical-mechanical polishing and/or by dry or wet etching.

12. The process for fabricating a laser according to one of claims 8 to 11, **characterized in that** the substrate and the top confinement layer are made of InP or GaAs.

FIG.1a

FIG.1b

FIG.1c

FIG.1d

$n_{za}$ ----

$n_e$ --

Indice de
réfraction

---- $n_e$

------- $n_{za}$

Champ
électrique

distance

**FIG.2a**

Champ
électrique

distance

**FIG.2b**

FIG.3a

FIG.3b

FIG.3c

FIG.3d

FIG.3e

FIG.3f

Recouvrement

FIG.4

**EP 3 465 846 B1**

## RÉFÉRENCES CITÉES DANS LA DESCRIPTION

**Documents brevets cités dans la description**

- WO 2103174945 A